# FASCICULE DE BREVET EUROPEEN

(11) **EP 1 451 102 B1**
(45) Date de publication et mention de la délivrance du brevet: **23.04.2008**
(21) Numéro de dépôt: 02801094.0
(22) Date de dépôt: 03.12.2002
(51) Int. Cl.: C01B 31/02, C23C 16/02

(54) **PROCEDE DE CROISSANCE CATALYTIQUE DE NANOTUBES OU NANOFIBRES COMPRENANT UNE BARRIERE DE DIFFUSION DE TYPE ALLIAGE NiSi**
VERFAHREN ZUM KATALYTISCHEN WACHSENLASSEN VON NANORÖHRCHEN ODER NANOFASERN MIT EINER DIFFUSIONSBARRIERE AUS NISI-LEGIERUNG
METHOD FOR CATALYTIC GROWTH OF NANOTUBES OR NANOFIBERS COMPRISING A NISI ALLOY DIFFUSION BARRIER

(30) Priorité: 04.12.2001 FR 0115647
(43) Date de publication de la demande: 01.09.2004
(73) Titulaire: Thales, 75008 Paris (FR)
(72) Inventeur: Legagneux, Pierre, 94117 Arcueil cedex (FR); Pribat, Didier, 94117 Arcueil Cedex (FR); Nedellec, Yannig, 94117 Arcueil Cedex (FR)
(86) Numéro de dépôt international: PCT/FR2002/004155
(87) Numéro de publication internationale: WO 2003/048040

(56) Documents cités:
- EP-A- 1 046 613
- EP-A- 1 059 266
- EP-A- 1 061 043
- EP-A- 1 129 990
- BIRO L P ET AL: "Selective nucleation and growth of carbon nanotubes at the CoSi/sub 2//Si interface" APPLIED PHYSICS LETTERS, 7 FEB. 2000, AIP, USA, vol. 76, no. 6, pages 706-708, XP002214127 ISSN: 0003-6951

## Description

Le domaine de l'invention est celui des nanotubes ou nanofibres pouvant être de type carbone, silicium, bore ou de tout autre alliage basé sur l'un au moins de ces composants (par exemple SiC) et pouvant comprendre de l'azote (SiN, BN, SiCN). Typiquement, ces nanotubes ou nanofibres présentent des diamètres de quelques nanomètres à quelques centaines de nanomètres sur plusieurs microns de hauteur.

Ils sont particulièrement intéressants pour la nanotechnologie, les matériaux composites, les électrodes de batterie, le stockage de l'énergie, la nanoélectronique, les dispositifs à émission de champ.

En ce qui concerne la nanotechnologie, les applications sont le design et l'engineering moléculaire, les nanopointes (pour la métrologie), les actuateurs, robots, capteurs et donc les MEMS (Micro electromechanichal systems).

En ce qui concerne le stockage de l'énergie, les applications sont la pile à combustible qui utilise les propriétés de stockage de l'hydrogène des nanotubes et aussi les supercapacités.

La nanoélectronique inclue les composants électroniques classiques (diodes, transistors, capacités), l'électronique moléculaire et les futurs composants pour les futurs ordinateurs (carbon nanotube molecular computer).

Dans le cas des dispositifs à émission de champ, les applications sont les sources froides d'électrons pour la microscopie électronique, les équipements d'analyse utilisant un faisceau électronique, la nanolithographie, les tubes électroniques, les propulseurs ioniques et les dispositifs d'affichage plats.

La croissance de nanotubes/nanofibres sur un substrat ou un support est effectuée sur des agrégats de catalyseur de très faibles dimensions (< 100 nm) à une température généralement supérieure à 500°C et pouvant dépasser les 1000°C.

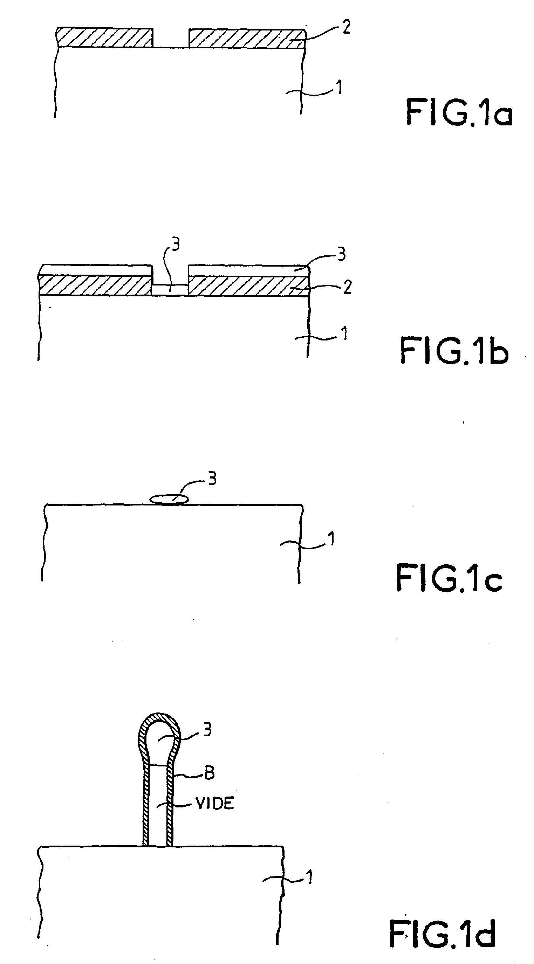

De manière classique, la réalisation de nanotubes ou nanofibres est effectuée par croissance à partir de plots de catalyseurs de faibles dimensions qui peuvent être définis par lithographie. La Figure 1 illustre une telle croissance. A partir d'un substrat 1, on effectue des ouvertures submicroniques (de préférence de l'ordre de 100nm) dans une résine 2, (Figure 1a). Puis on dépose du catalyseur en couche mince 3, sur une épaisseur inférieure à environ 10nm (Figure 1b). Après une étape de dissolution de la résine (Figure 1c), on obtient des plots de catalyseurs de diamètre équivalent au diamètre des ouvertures de la résine. On procède alors à la croissance de nanotubes ou nanofibres (Figure 1 c).

Les méthodes de préparation sont : la décharge électrique, la pyrolise, les méthodes par voie physique telle que l'ablation laser et les méthodes par voie chimique CVD (chemical vapor deposition) ou PECVD (Plasma enhanced CVD).

La méthode qui semble la mieux adaptée pour l'application cathode à effet de champ est la méthode PECVD qui est assistée par plasma DC (plasma continu), RF (radio fréquence) ou microonde. En effet, elle permet l'obtention de nanotubes et nanofibres orientés perpendiculairement par rapport au substrat.

Les nanotubes ou nanofibres montrés sur toutes les figures de la demande sont dessinés de façon schématique. Les nanotubes contrairement aux nanofibres sont creux

Par exemple, dans le cas de nanotubes de carbone, le diamètre des nanotubes est proche de celui de la particule de catalyseur. Du fait de la forme allongée que prend cette particule (voir Figure 1d) en matériau B (pouvant être C, SiC, BN, ....), son diamètre est plus faible que celui des plots préalablement définis par lithographie.

Néanmoins, si lors de l'étape de mise en température du substrat ou support, les agrégats de catalyseur diffusent ou sont dissous dans le substrat ou support, il n'y aura pas alors de croissance de nanotubes/nanofibres. Il est donc primordial de déposer une barrière de diffusion efficace préalablement au dépôt du catalyseur. Si la barrière est peu efficace, la croissance des nanotubes/nanofibres sera mal contrôlée.

Les barrières de diffusion utilisées actuellement sont généralement la silice (SiO₂) et le nitrure de titane (TiN). SiO₂ est une excellente barrière mais c'est un matériau isolant et donc peu adapté dans le cas où il est nécessaire de connecter électriquement les nanotubes. On notera que SiO₂ peut cependant être utilisé en couche très mince (2-4 nm) et que dans ce cas, le passage du courant peut s'effectuer par effet tunnel. SiO₂ se dégrade rapidement lors du passage du courant électrique et il perd alors ses propriétés isolantes. Le TiN est aussi une excellente barrière de diffusion mais uniquement pour des températures de croissance de nanotubes inférieures à 700°C. En effet à partir de 700°C, l'azote constituant le TiN exodiffuse et le matériau perd alors ses propriétés de barrière de diffusion.

Le document EP-A-1046613 propose un procédé de croissance de nanotubes de carbone sur un substrat recouvert d'une couche de silicuim amorphe puis d'une couche de nickel. Lors du procédé, le silicum cristallise par diffusion d'une partie du nickel. L'exédant de nickel resté en surface agit comme catalyseur de croissance.

Dans ce contexte, l'invention propose d'utiliser des barrières de diffusion originales destinées à la croissance catalytique de nanotubes et nanofibres, et adaptées aux catalyseurs de type nickel, cobalt, fer, platine, yttrium ou de tout autre alliage basé sur l'un au moins de ces composants.

Plus précisément, l'invention a pour objet un procédé de croissance de nanotubes ou nanofibres sur un substrat comportant au moins une couche supérieure en un premier matériau, caractérisé en ce qu'il comprend :
- la formation à la surface de la couche supérieure, d'une couche barrière constituée d'un alliage du premier matériau et d'un second matériau, ledit alliage étant stable à une première température ;
- la formation de plots de catalyseur constitués du second matériau, à la surface de la couche d'alliage ;
- la croissance de nanotubes ou nanofibres à une seconde température inférieure à ladite première température.

Selon une variante de l'invention, la formation de la couche barrière comprend le dépôt d'une couche constituée du second matériau, à la surface de la couche supérieure constituée du premier matériau, puis le recuit à ladite première température.

L'invention consiste ainsi à déposer une couche mince de second matériau constitutif du catalyseur, sur la couche supérieure de premier matériau, puis à effectuer un recuit à une température supérieure ou égale à la température de croissance des nanofibres/nanotubes. On forme ainsi un alliage stable à la température de recuit Tᵣ et donc à la température de croissance T_{c} des nanotubes/nanofibres (on a T_{c} < Tᵣ). De ce fait, lorsque l'on utilise ultérieurement des plots de catalyseur, ceux-ci ne réagissent pas avec l'alliage formé préalablement et permettent une croissance catalytique de nanotubes/nanofibres, efficace.

Selon une variante de l'invention le procédé comprend le dépôt d'une couche de catalyseur constituée du second matériau à la surface de la couche d'alliage puis la gravure locale de ladite couche de catalyseur de manière à définir les plots de catalyseurs.

Avantageusement on peut avoir préalablement réaliser des plots de résine sur la couche d'alliage.

Selon une variante de l'invention, le premier matériau et le substrat sont de nature identique.

Selon une autre variante de l'invention le premier matériau et le substrat sont de nature différente. Dans ce cas, avantageusement si la couche supérieure de premier matériau comporte un premier nombre d'atomes N_{M}, et la couche de second matériau comporte un second nombre d'atomes N_{A}, en réglant N_{M}/N_{A} < x/y avec x et y fractions molaires de l'alliage MₓA_{y}, on parvient lors de la formation de l'alliage, avec le second matériau en excès (par rapport à la formation de l'alliage) à former directement des plots de catalyseur dudit second matériau. Dans ce cas on peut s'affranchir du dépôt ultérieur d'une couche de catalyseur pour former des plots de catalyseur en vue de la formation des nanotubes/nanofibres.

Avantageusement le premier matériau peut-être du silicium ou un métal.

Lorsque la couche d'alliage est obtenue après dépôt d'une couche de second matériau sur la couche supérieure à la surface du substrat et recuit de l'ensemble, cette couche d'alliage peut typiquement avoir une épaisseur comprise entre environ une dizaine de nanomètres et une centaine de nanomètres.

L'invention sera mieux comprise et d'autres avantages apparaîtront à la lecture de la description qui va suivre et grâce aux figures annexées parmi lesquelles :
- les figures 1a-1d illustrent les étapes d'un procédé de croissance catalytique de nanofibres/nanotubes, selon l'art connu,
- les figures 2a-2e illustrent les étapes d'un exemple de procédé de croissance de nanotubes/nanofibres selon l'invention,
- les figures 3a-3c illustrent les étapes d'un second exemple de procédé de croissance de nanotubes/nanofibres selon l'invention.

Selon l'invention le procédé de croissance de nanotubes/nanofibres comprend la réalisation d'une couche barrière vis-à-vis d'une couche de catalyseur, nécessaire à la croissance des nanotubes/nanofibres.

Selon une variante de l'invention, le procédé comprend la réalisation d'une couche de cobalt d'environ une cinquantaine de nanomètres à la surface d'une couche de silicium, pour réaliser l'alliage C_{O}Si₂.

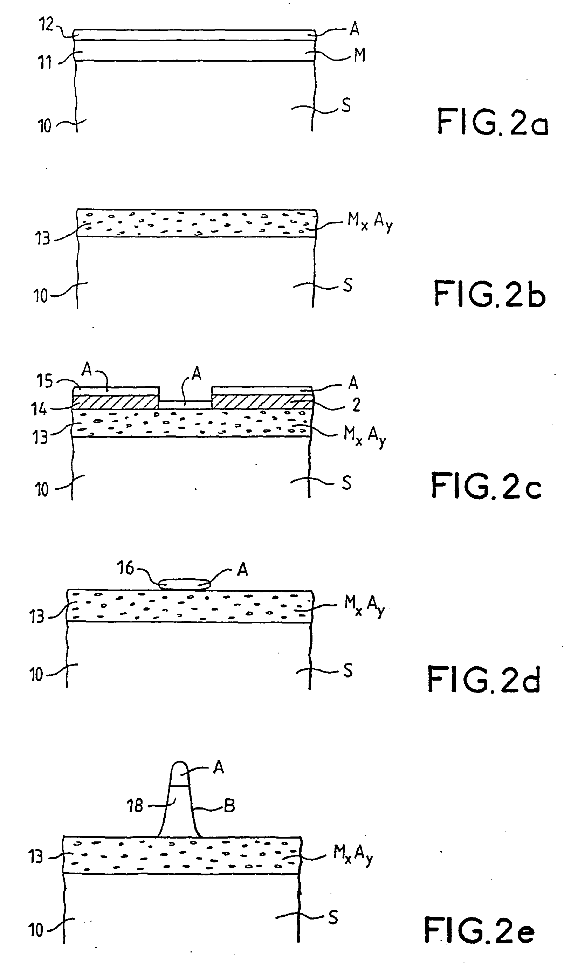

La Figure 2 illustre un premier exemple de procédé selon l'invention, dans lequel le substrat et le matériau de la couche supérieure sont de nature différente. (Néanmoins selon d'autres variantes de l'invention, le substrat S peut être lui-même en matériau M).

Selon une première étape, la couche barrière est réalisée par le dépôt préalable d'une couche 12 de matériau A à la surface d'une couche 11 supérieure de matériau M elle-même à la surface d'un substrat S (figure 2a).

On procède alors à une opération de recuit à une température Tᵣ qui permet la formation d'une couche 13 d'alliage MₓA_{y} (Figure 2b).

De manière classique, on dépose alors une couche 14 de résine 2, que l'on grave. Puis on dépose une couche 15 de matériau catalyseur A (Figure 2c). Après retrait de la résine et excédent de matériau catalyseur A (Figure 2d), on définit des plots 16 de catalyseur A. On procède alors à la croissance des nanotubes 18 d'un matériau B à une température T_{c} inférieure à la température Tᵣ (Figure 2e), le matériau B pouvant être de type C, SiC, BN...

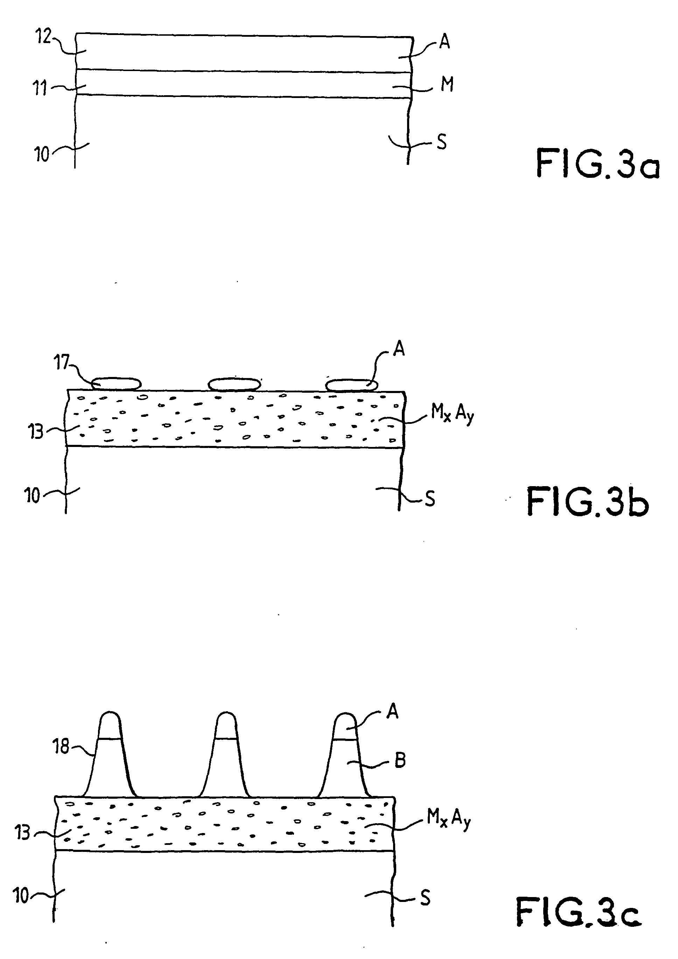

La Figure 3 illustre un second exemple de procédé selon l'invention dans lequel le choix judicieux des quantités de matériau de catalyseur et de premier matériau permettent de former simultanément une couche d'alliage MₓA_{y} et des plots de catalyseur en matériau A.

A titre d'exemple on peut citer qu'une couche en matériau M en silicium d'épaisseur 185 Å et une couche en matériau A en nickel d'épaisseur 100 Å, forme à 750°C une couche uniforme d'alliage NiSi. Un défaut de silicium ou un excès de nickel permettent à cette même température de former une couche d'alliage NiSi avec des plots résiduels en surface de Ni qui pourront directement être utilisés pour la croissance de nanotubes.

Ainsi selon la Figure 3a, on dépose comme dans l'exemple illustré en Figure 2a une couche 11 de matériau M à la surface du substrat S, puis une couche 12 de matériau A à la surface de la couche 11. Les matériaux M et le substrat S doivent être de nature différente pour permettre de maintenir le matériau A en excès par rapport au matériau M.

L'opération de recuit permet la formation simultanée d'une couche 13 d'alliage MₓA_{y} et de plots 17 de catalyseur correspondant à l'excès de matériau A par rapport au matériau M lors de la formation de l'alliage (Figure 3b).

On procède alors de manière classique à la croissance de nanofibres/nanotubes 18 à partir desdits pots de catalyseur (Figure 3c).

### Exemple de procédé de croissance de nanotubes selon l'invention :

### 1^{er} exemple :

### Matériau M : Silicium

### Matériau A : Nickel

Dans le cas d'un substrat de silicium ou d'une couche mince de silicium déposé sur un substrat, on dépose une couche mince de nickel sur le silicium. On effectue alors une opération de recuit à 750°C de façon à fournir le composé NiSi.

L'ajout de platine permet d'éviter la formation de l'alliage NiSi₂ et donc d'obtenir uniquement le composé NiSi (J.F. Liu et al., J. Appl. Phys. Vol. 90 p. 745 (2001). L'alliage NiSi constitue alors une barrière de diffusion efficace pour le nickel, si la température de croissance de nanotubes est inférieure à 750 °C. Notons que la croissance localisée et orientée de nanotubes de carbone peut être obtenue à 700°C (K.B.K. Teo et al., Appl. Phys. Lett. Vol. 79 p. 1534 (2001)).

On peut aussi effectuer le recuit à 850°C de façon à former NiSi₂ qui constitue une barrière de diffusion pour des nanotubes/nanofibres dont la température de croissance est inférieure à 850°C.

Une température de croissance des nanotubes plus élevée (∼800°C au lieu de 700°C) permet généralement d'obtenir des nanotubes de meilleure qualité cristalline et donc caractérisés par de meilleures propriétés électriques.

Après réalisation d'une barrière de diffusion NiSi (formée à 750°C) ou NiSi₂ (formée à 850°C), on peut alors effectuer la croissance localisée et orientée de nanotubes de carbone à une température de 700°C. Afin d'obtenir la croissance d'un seul nanotube par plot de catlyseur, on définit par lithographie des plots de Nickel de diamètre de l'ordre de 100 nm et d'épaisseur 10 nm. La croissance peut alors être effectuée à 700°C dans un réacteur CVD assisté par un plasma DC (continu) avec une tension de l'ordre de 600 Volts. Un mélange gazeux contenant de l'acétylène et de l'amoniaque (∼20% d'acétylène) à une pression d'environ 5 Torr permet alors d'obtenir une croissance orientée et sélective de nanotubes de carbone (K.B.K. Teo et al., Appl. Phys. Lett. Vol. 79 p. 1534 (2001)).

### 2^{ème} exemple :

### Matériau M : Silicium

### Matériau A : Cobalt

Selon ce second exemple, on réalise le dépôt d'une couche de cobalt à la surface d'une couche de silicium. Pour obtenir un alliage homogène de C_{O}Si₂ et donc éviter la formation de la phase CoSi, on peut avantageusement effectuer le recuit à une température supérieure à 600°C.

Une épaisseur de l'ordre de 30 à 60nm de cobalt permet d'obtenir après recuit à 800°C l'alliage CoSi₂ (Y. J. Yoon, J. Vac. Sci. Technol. B17 p.627 (1999). Ce composé formé à 800°C devient alors une barrière de diffusion efficace pour le catalyseur en cobalt, si la température de croissance des nanotubes est inférieure à 800°C.

### 3^{ème} exemple :

### Matériau M : Silicium

### Matériau A : Fer

On peut avantageusement former une couche barrière en FeSi₂, à partir du recuit à 700°C d'une couche de fer à la surface de silicium. Cette couche barrière peut être utilisée pour la croissance de nanotubes/nanofibres à des températures inférieures à 700°C.

## Revendications

1. Procédé de croissance de nanotubes ou nanofibres sur un substrat (S) comportant au moins une couche supérieure (11) en un premier matériau (M), **caractérisé en ce qu'**il comprend :
- la formation à la surface de la couche supérieure, d'une couche barrière (13) constituée d'un alliage (MₓA_{y}) du premier matériau (M) et d'un second matériau (A), ledit alliage étant stable à une première température ;
- la formation de plots de catalyseur (16, 17) constitués du second matériau (A), à la surface de la couche d'alliage ;
- la croissance de nanotubes ou nanofibres (18) à une seconde température inférieure à ladite première température.

2. Procédé de croissance de nanotubes ou nanofibres selon la revendication 1, **caractérisé en ce que** la formation de la couche barrière comprend le dépôt d'une couche (12) constituée du second matériau (A), à la surface de la couche supérieure (11) constituée du premier matériau, puis le recuit à ladite première température.

3. Procédé de croissance de nanotubes ou nanofibres selon l'une des revendications 1 ou 2, **caractérisé en ce qu'**il comprend :
- le dépôt d'une couche de catalyseur (15), constituée du second matériau (A) à la surface de la couche d'alliage (MₓA_{y})
- la gravure locale de ladite couche de catalyseur, de manière à définir des plots de catalyseur (16).

4. Procédé de croissance de nanotubes ou nanofibres selon l'une des revendications 1 à 3, **caractérisé en ce que** le premier matériau et le substrat sont de nature identique.

5. Procédé de croissance de nanotubes ou nanofibres selon l'une des revendications 1 à 3, **caractérisé en ce que** le premier matériau et le substrat sont de nature différente.

6. Procédé de croissance de nanotubes ou nanofibres selon la revendication 5, **caractérisé en ce que** la couche supérieure (11) de premier matériau comportant un premier nombre d'atomes N_{M}, la couche (12) de second matériau comportant un second nombre d'atomes N_{A}, les nombres N_{M} et N_{A} sont tel que N_{M}/N_{A} < x/y avec x et y fractions molaires de l'alliage MₓA_{y}.

7. Procédé de croissance de nanotubes ou nanofibres selon l'une des revendications 1 à 6, **caractérisé en ce que** le premier matériau est du silicium ou un métal.

8. Procédé de croissance de nanotubes ou nanofibres selon la revendication 7, **caractérisé en ce que** le second matériau est de type nickel, fer ou cobalt.

9. Procédé de croissance de nanotubes ou nanofibres selon la revendication 8, **caractérisé en ce que** le premier matériau est du silicium, le second matériau est du nickel et la formation de l'alliage NiSi est effectuée en présence de platine.

10. Procédé de croissance de nanotubes ou nanofibres selon l'une des revendications 1 à 9, **caractérisé en ce que** la couche de second matériau a une épaisseur comprise entre environ 10 nanomètres et 100 nanomètres.

11. Procédé de croissance de nanotubes ou nanofibres, selon les revendications 7 et 8, **caractérisé en ce qu'**il comprend la réalisation d'une couche de cobalt d'environ une cinquantaine de nanomètres à la surface d'une couche de silicium, pour réaliser l'alliage CoSi₂.

12. Procédé de croissance de nanotubes ou nanofibres, selon les revendications 7 et 8, **caractérisé en ce qu'**il comprend la réalisation d'un alliage FeSi₂.

## Claims

1. Process for the growth of nanotubes or nanofibers on a substrate (S) comprising at least an upper layer (11) made of a first material (M), **characterized in that** it comprises :
- the formation, on the surface of the upper layer, of a barrier layer (13) made of an alloy (MₓA_{y}) of the first material (M) and of a second material (A), said alloy being stable at a first temperature;
- the formation of spots of catalyst (16, 17) that are made of the second material (A), on the surface of the alloy layer; and
- the growth of nanotubes or nanofibers (18) at a second temperature below said first temperature.

2. Nanotube or nanofiber growth process according to Claim 1, **characterized in that** the formation of the barrier layer comprises the deposition of a layer (12) made of the second material (A) on the surface of the upper layer (11) made of the first material, followed by annealing at said first temperature.

3. Nanotube or nanofiber growth process according to either of Claims 1 and 2, **characterized in that** it comprises:
- the deposition of a catalyst layer (15) made of the second material (A) on the surface of the alloy layer (MₓA_{y}); and
- the local etching of said catalyst layer so as to define catalyst spots (16).

4. Nanotube or nanofiber growth process according to one of Claims 1 to 3, **characterized in that** the first material and the substrate are of identical nature.

5. Nanotube or nanofiber growth process according to one of Claims 1 to 3, **characterized in that** the first material and the substrate are of different nature.

6. Nanotube or nanofiber growth process according to Claim 5, **characterized in that** with the upper layer (11) of first material having a first number of atoms N_{M}, and the layer (12) of second material having a second number of atoms N_{A}, the numbers N_{M} and N_{A} are such that N_{M}/N_{A} < x/y where x and y are molar fractions of the alloy MₓA_{y}.

7. Nanotube or nanofiber growth process according to one of Claims 1 to 6, **characterized in that** the first material is silicon or a metal.

8. Nanotube or nanofiber growth process according to Claim 7, **characterized in that** the second material is of the nickel, iron or cobalt type.

9. Nanotube or nanofiber growth process according to Claim 8, **characterized in that** the first material is silicon, the second material is nickel and the NiSi alloy is formed in the presence of platinum.

10. Nanotube or nanofiber growth process according to one of Claims 1 to 9, **characterized in that** the layer of second material has a thickness of between about 10 nanometers and 100 nanometers.

11. Nanotube or nanofiber growth process according to Claims 7 and 8, **characterized in that** it includes the production of a cobalt layer of about fifty nanometers on the surface of a silicon layer, in order to produce the CoSi₂ alloy.

12. Nanotube or nanofiber growth process according to Claims 7 and 8, **characterized in that** it includes the production of an FeSi₂ alloy.

## Patentansprüche

1. Wachstumsverfahren von Nanoröhrchen oder Nanofasern auf einem Substrat (S), das mindestens eine obere Schicht (11) aus einem ersten Material (M) aufweist, **dadurch gekennzeichnet, dass** es Folgendes aufweist:
- das Bilden auf der Oberfläche der oberen Schicht einer Barriereschicht (13) bestehend aus einer Legierung (MₓA_{y}) des ersten Materials (M) und eines zweiten Materials (A), wobei die Legierung bei einer ersten Temperatur beständig ist;
- Ausbilden von Katalysatorklötzchen (16, 17), die aus dem zweiten Material (A) bestehen, auf der Oberfläche der Legierungsschicht;
- das Wachsen von Nanoröhrchen oder Nanofasern (18) bei einer zweiten Temperatur, die niedriger ist als die erste Temperatur.

2. Wachstumsverfahren von Nanoröhrchen oder Nanofasern nach Anspruch 1, **dadurch gekennzeichnet, dass** das Bilden der Barriereschicht das Ablagern einer Schicht (12) aufweist, die aus dem zweiten Material (A) besteht, auf der Oberfläche der oberen Schicht (11), die aus dem ersten Material besteht, danach das Glühen bei der ersten Temperatur.

3. Wachstumsverfahren von Nanoröhrchen oder Nanofasern nach einem der Ansprüche 1 oder 2, **dadurch gekennzeichnet, dass** es Folgendes aufweist:
- das Ablagern einer Katalysatorschicht (15) bestehend aus dem zweiten Material (A) auf der Oberfläche der Legierungsschicht (MₓA_{y})
- das lokale Gravieren der Katalysatorschicht, so dass Katalysatorklötzchen (16) definiert werden.

4. Wachstumsverfahren von Nanoröhrchen oder Nanofasern nach einem der Ansprüche 1 bis 3, **dadurch gekennzeichnet, dass** das erste Material und das Substrat identischer Beschaffenheit sind.

5. Wachstumsverfahren von Nanoröhrchen oder Nanofasern nach einem der Ansprüche 1 bis 3, **dadurch gekennzeichnet, dass** das erste Material und das Substrat unterschiedlicher Beschaffenheit sind.

6. Wachstumsverfahren von Nanoröhrchen oder Nanofasern nach Anspruch 5, **dadurch gekennzeichnet, dass** die obere Schicht (11) aus erstem Material eine erste Anzahl Atome N_{M} aufweist, die Schicht (12) aus zweitem Material eine zweite Anzahl Atome N_{A} aufweist, wobei die Anzahlen N_{M} und N_{A} derart sind, dass N_{M}/N_{A} < x/y ist, wobei x und y Molanteile der Legierung MₓA_{y} sind.

7. Wachstumsverfahren von Nanoröhrchen oder Nanofasern nach einem der Ansprüche 1 bis 6, **dadurch gekennzeichnet, dass** das erste Material Silizium oder ein Metall ist.

8. Wachstumsverfahren von Nanoröhrchen oder Nanofasern nach Anspruch 7, **dadurch gekennzeichnet, dass** das zweite Material des Typs Nickel, Eisen oder Kobalt ist.

9. Wachstumsverfahren von Nanoröhrchen oder Nanofasern nach Anspruch 8, **dadurch gekennzeichnet, dass** das erste Material Silizium, das zweite Material Nickel ist und dass das Bilden der NiSi-Legierung in Gegenwart von Platin erfolgt.

10. Wachstumsverfahren von Nanoröhrchen oder Nanofasern nach einem der Ansprüche 1 bis 9, **dadurch gekennzeichnet, dass** die Schicht aus zweitem Material eine Stärke zwischen etwa 10 Nanometer und 100 Nanometer hat.

11. Wachstumsverfahren von Nanoröhrchen oder Nanofasern nach den Ansprüchen 7 und 8, **dadurch gekennzeichnet, dass** es das Herstellen einer Kobaltschicht mit etwa 50 Nanometer auf der Oberfläche einer Siliziumschicht zum Herstellen der CoSi₂-Legierung aufweist.

12. Wachstumsverfahren von Nanoröhrchen oder Nanofasern nach den Ansprüchen 7 und 8, **dadurch gekennzeichnet, dass** es das Herstellen einer FeSi₂-Legierung aufweist.
